## Europäisches Patentamt

(19) **European Patent Office**

**Office européen des brevets**

(11) Publication number: **0 199 388**
**B1**

(12) # EUROPEAN PATENT SPECIFICATION

(45) Date of publication of the patent specification:
27.12.90

(51) Int. Cl.⁵: **H01L 21/268,** H01L 21/20

(21) Application number: **86200459.5**

(22) Date of filing: **20.03.86**

(54) Method of converting polycrystalline semiconductor material into monocrystalline semiconductor material.

(30) Priority: **29.03.85 NL 8500931**

(43) Date of publication of application:
**29.10.86 Bulletin 86/44**

(45) Publication of the grant of the patent:
**27.12.90 Bulletin 90/52**

(84) Designated Contracting States:
**DE FR GB IT NL**

(56) References cited:
**EP-A- 0 028 934**
**EP-A- 0 078 681**
**EP-A- 0 109 499**
**EP-A- 0 127 323**
**GB-A- 2 075 749**

**JAPANESE JOURNAL OF APPLIED PHYSICS, vol. 22,
supplement 22-1, 1983, pages 205-208, Tokyo, JP; J.P.
COLINGE et al.: "The use of selective annealing for
growing very large grains in silicon on insulator films"
IEEE ELECTRON DEVICE LETTERS, vol. EDL-3, no. 12,
December 1982, pages 369-372, IEEE, New York, US;
N.M. JOHNSON et al.: "Single-crystal silicon transistors
in laser-crystallized thin films on bulk glass"
APPLIED PHYSICS LETTERS, vol. 45, no. 8, 15th
October 1984, pages 854-856, American Institute of**

(73) Proprietor: **N.V. Philips' Gloeilampenfabrieken,
Groenewoudseweg 1, NL-5621 BA Eindhoven(NL)**

(72) Inventor: **Haisma, Jan, c/o INT. OCTROOIBUREAU B.V.
Prof. Holstlaan 6, NL-5656 AA Eindhoven(NL)**
Inventor: **Theunissen, Matthias Johannes Joseph, c/o
INT. OCTROOIBUREAU B.V. Prof. Holstlaan 6,
NL-5656 AA Eindhoven(NL)**
Inventor: **Pasmans, Johannes Maria Marinus, c/o INT.
OCTROOIBUREAU B.V. Prof. Holstlaan 6, NL-5656 AA
Eindhoven(NL)**
Inventor: **Widdershoven, Franciscus Petrus, c/o INT.
OCTROOIBUREAU B.V. Prof. Holstlaan 6, NL-5656 AA
Eindhoven(NL)**
Inventor: **Van der Werf, Pieter, c/o INT.
OCTROOIBUREAU B.V. Prof. Holstlaan 6, NL-5656 AA
Eindhoven(NL)**

(74) Representative: **Rensen, Jan Geert et al, Internationaal
Octrooibureau B.V. Prof. Holstlaan 6, NL-5656 AA
Eindhoven(NL)**

(56) References cited: (continuation)
**Physics, New York, US; K. EGAMI et al.: "Strong [100]
texture formation of polycrystalline silicon films on
amorphous insulator by laser recrystallization" 000
IBM TECHNICAL DISCLOSURE BULLETIN, vol. 22,
no. 12, May 1980, pages 5473-5474, New York, US; A.B.
FOWLER et al.: "Selective laser annealing through
quarter- and half-wave coatings"**

## Description

The invention relates to a method of converting polycrystalline or amorphous semiconductor material into monocrystalline semiconductor material, in which on a substrate a layer structure comprising a layer of polycrystalline or amorphous semiconductor material between a first electrically insulating layer and a coating layer is irradiated by a radiation source which supplies practically monochromatic electromagnetic radiation, to which the polycrystalline or amorphous semiconductor material is practically completely transparent at least at room temperature, the energy being sufficient to heat the layer structure in such a manner that the polycrystalline or amorphous semiconductor material is converted at least locally into monocrystalline semiconductor material.

Methods of this kind may be advantageously used, for example, in the manufacture of so-called three-dimensional integrated circuits, in which, after an insulating layer has been applied, which protects underlying circuits, such as memory matrices registers, multiplexers etc., from the influences of further operations, again monocrystalline regions have to be applied on this insulating layer for transistors or other circuit elements. Another field of use is, for example, the manufacture of monocrystalline semiconductor material on an insulating substrate on behalf of opto-electronic elements.

A method of the kind mentioned in the opening paragraph is known from Japanese Patent Application laid open to public inspection Kokai No. 57-124423. By means of the method described therein, a layer of polycrystalline silicon located between two $SiO_2$ layers is recrystallized by irradiating it by electromagnetic radiation originating from a $CO_2$ laser. The wavelength of this radiation is about 10 μm, to which the polycrystalline silicon is substantially completely transparent at room temperature so that substantially no energy is absorbed herein on behalf of recrystallization.

In general, a radiation source is therefore preferably chosen which has such a wavelength that the semiconductor material absorbs the largest possible amount of energy, as in the case of polycrystalline silicon for example an argon ion laser. On the other hand, the use of, for example, a $CO_2$ laser has, apart from the lower absorption in polycrystalline silicon, various advantages as compared with the argon ion laser. In the first place, the emission is more stable and hence the intensity of the emitted radiation is more constant. Besides, the power of a $CO_2$ laser is considerably higher than that of an argon ion laser, while the light output is higher. Moreover, the cost price is more favourable. In addition, due to the higher power, several beams can be produced simultaneously by a $CO_2$ laser, which is favourable for given applications.

The invention has for its object to provide a method, in which radiation is used, to which polycrystalline semiconductor material is practically completely transparent, and nevertheless a sufficient absorption occurs in the layer structure to rapidly heat the semiconductor material to temperatures at which a substantially complete absorption is obtained.

The invention is based on the recognition of the fact that this can be achieved by a suitable construction of the layer structure, especially by mutually adapting the thicknesses of the various layers in such a manner that the first electrically insulating layer and the coating layer are rapidly heated. As a result, the interposed semiconductor material is also heated comparatively rapidly to a temperature at which it behaves practically metallically and absorbs a larger part of the radiation. If desired, the whole may be heated more rapidly by heating, as the case may be temporarily, by means of a heating element.

Therefore, the method according to the invention is characterized in that the coating layer in the layer structure has a thickness of practically $m/4\lambda^{I}$ and the layer of polycrystalline semiconductor material and the electrically insulating layer have thicknesses of practically $n/4\lambda^{II}$ and $n'/4\lambda^{III}$, respectively, where m is even, n and n' are odd and $\lambda^{I}$, $\lambda^{II}$ and $\lambda^{III}$ are the wavelengths of the electro-magnetic radiation in the coating layer, the layer of polycrystalline semiconductor material and the first electrically insulating layer, respectively.

With such a layer structure, an absorption at room temperature of about 8% can be reached, while only 32 % of the radiation energy is supplied to the underlying substrate. In the structure as shown in Japanese Patent Application laid open to public inspection Kokai No. 57-124423, a thickness of the coating layer is not mentioned, it is true, but with usual thicknesses of this layer still more than about 60 % of the electromagnetic energy is supplied to the underlying substrate, while with the relevant thickness of the coating layer the absorption in the layer structure is very low (about 1 %).

The invention will now be described more fully with reference to a few embodiments and the drawing, in which:

Fig. 1 shows a layer structure suitable for a method according to the invention, while

Fig. 2 illustrates diagrammatically the variation as a function of the thickness of the layer of polycrystalline semiconductor material of the absorption, the transmission and the reflection in such a layer of energy supplied by a monochromatic radiation source, and

Fig. 3 shows a multilayer structure suitable for use of a method according to the invention.

The figures are schematic and not drawn to scale. Corresponding elements are generally designated by the same reference numerals.

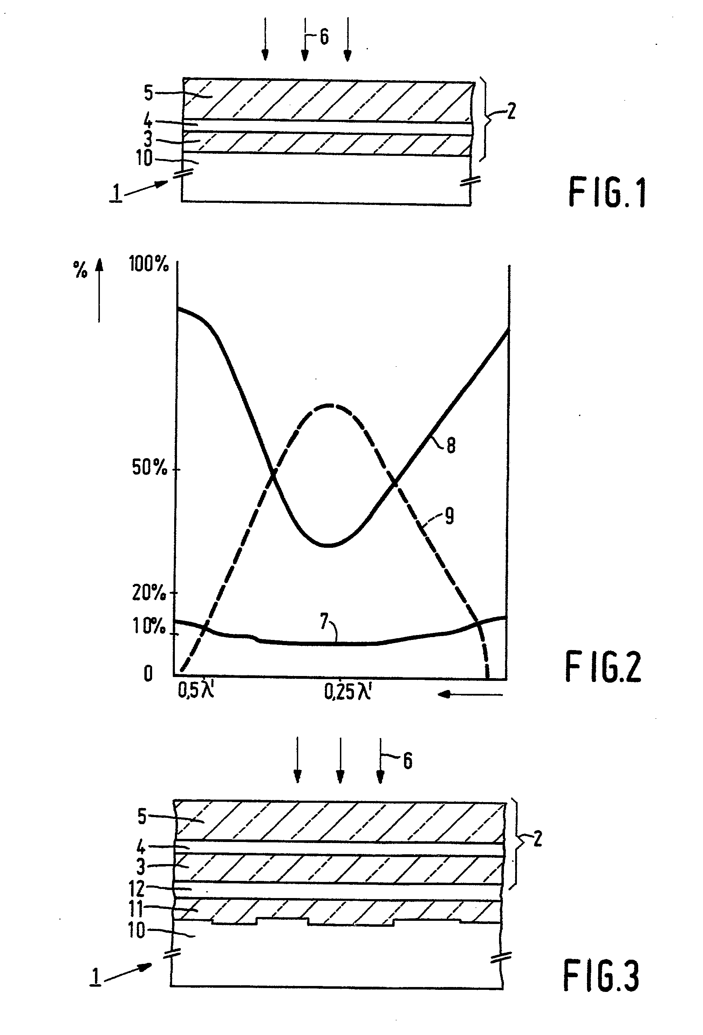

Fig. 1 shows a device 1 comprising on a substrate 10 a layer structure 2. The substrate 10 is, for example, a silicon body and may comprise, for example, finished semiconductor circuits. However, the substrate 10 may alternatively consist of electrically insulating material (glass or sapphire). The layer structure 2 in this embodiment comprises a first layer 3 of silicon dioxide having a thickness of about 1.25 µm, which corresponds to about $1/4\lambda^{III}$, where $\lambda^{III}$ is the wavelength in silicon dioxide of the radiation emitted by a $CO_2$ laser (about 10.6 µm in vacuo), and a polycrystalline silicon layer 4 having a thickness of about 0.77 µm, which corresponds to about $1/4\lambda^{II}$, where $\lambda^{II}$ is the wavelength in polycrystalline silicon of such a radiation. The layer structure further comprises a coating layer 5 of silicon dioxide having a thickness of about 2.5 µm corresponding to about $1/2\lambda^{I}$, where $\lambda^{I}$ is again the wavelength in silicon dioxide of the radiation emitted by a $CO_2$ laser. If desired, thin layers (not shown) of, for example, silicon nitride may be situated between the various layers and these thin layers may act as diffusion inhibitors and ensure a better wetting or a satisfactory thermal and mechanical adaptation. The overall thickness of the double layer comprising an intermediate layer and the layers 5,4,3 is again about $1/2\lambda^{I}$, $1/4\lambda^{II}$ and $1/4\lambda^{III}$, respectively.

In certain applications, for example, in the manufacture of so-called three-dimensional IC's or layers of polycrystalline silicon applied to electrically insulating substrates, it is desirable to convert the layer 4 completely or in part into monocrystalline silicon in order that active elements, such as transistors or other circuit elements, can be formed therein.

In accordance with the invention, the layer structure 2 is irradiated for this purpose by monochromatic radiation 6 originating from a $CO_2$ laser. At room temperature, the layer 4 transmits such a radiation substantially completely, however, so that without special steps the desired heating to the melting point and the subsequent recrystallization to monocrystalline silicon require a considerable amount of energy and time. A large part of the non-absorbed energy may additionally penetrate into the substrate 10 and cause damage therein; thus, if circuits have already been formed, conductor tracks may melt entirely or in part due to the heating, while out-diffusion may occur in semiconductor zones due to the increased temperature.

The layer structure shown here absorbs in the first instance a sufficient amount of energy in the layers 3 and 5, however, to rapidly heat the polycrystalline silicon layer 4 to a temperature of practically 800°C. At this temperature (and higher temperatures) the silicon has a substantially metallic character for the relevant wavelength and substantially the whole amount of energy is absorbed in the layer 4. This rapid heating of the layer structure 2 is reached already with an absorption in the layer structure 2 from about 4 % of the energy of the radiation 6 (at room temperature). The process of heating can be accelerated by heating the device 1, if desired, beforehand by other means, for example by placing the whole on a substrate heater. The temperature in the substrate 10 must of course not increase to such an extent that the aforementioned damage occurs.

Although in the layer structure 2 of Fig. 1 thicknesses are chosen for the layers 3, 4 and 5 which are closely related to the wavelength used for the radiation used, a certain variation is possible around these thicknesses, whilst nevertheless the condition is satisfied that the absorption is sufficiently high (4 % or more) and nevertheless the transmission of the radiation 6 and hence the part of the energy reaching the substrate 10 remains at an acceptable level (< 60 %).

This is explained with reference to Fig.2, in which for the layer structure 2 the absorption (curve 7), the transmission (curve 8) and the reflection (curve 9) for the radiation 6 having a wavelength of 10.6 µm, respectively, are shown with varying thickness of the intermediate layer 4, as obtained at room temperature. It appears from the Figure that the transmission is low (< 45 %) with a sufficiently high absorption (> 8 %) when the thickness of the polycrystalline silicon varies between $0.2\lambda^{II}$ and $0.3\lambda^{II}$.

In a similar manner, a certain spread in the thicknesses of the coating layer and the first electrically insulating layer proves to be possible around the values $1/2\lambda^{I}$ and $1/4\lambda^{III}$, respectively, whilst the absorption still amounts to at least 4 % with an admissible transmission (<60 %). It should be noted that between the polycrystalline silicon layer 4 and the $SiO_2$ layers 3,5 adapted thin layers (about 10-20 nm) may be provided consisting, for example, of silicon nitride. These layers serve on the one hand to obtain a satisfactory adhesion between the layers and on the other hand to optimize the temperature profile in the layer structure or to neutralize mechanical stresses. Moreover, silicon nitride has a satisfactory etching selectivity and a chemically inert character.

In a more general sense, it has been found that the aforementioned condition (absorption > 4 % with a transmission < 60%) is satisfied when for the top layer a thickness of approximately $m/4\lambda^{I}$ is chosen, where $\underline{m}$ is an even number, and when for the intermediate layer and the first electrically insulating layer thicknesses of approximately $n/4\lambda^{II}$ and $n'/4\lambda^{III}$ are chosen, where $\underline{n}$ and $\underline{n'}$ are odd numbers.

Fig. 3 finally shows an extension of the multilayer structure 2 with a subjacent additional polycrystalline silicon layer 12, which is separated from a substrate 10 by an additional electrically insulating layer 11 of silicon oxide.

The polycrystalline layer 12 may be, for example, heavily doped and may form part of a wiring pattern connecting circuit elements formed in the substrate 10 to semiconductor elements to be provided in the monocrystalline silicon to be formed. It also holds for this structure that with irradiation by electromagnetic radiation 6 originating from a $CO_2$ laser recrystallization of the layers 4 and 12 occurs with thicknesses of the layers 3,4,5, as indicated above. A further optimization is obtained by again choosing for the layers 11 and 12 thicknesses of approximately 1.25 µm and 0.77 µm, respectively.

In a more general sense, for the layers 11 and 12 thicknesses are chosen around values of $n''/4\lambda^{IV}$ and $n'''/4\lambda^{V}$, where n" and n''' are odd, while $\lambda^{IV}$ and $\lambda^{V}$ are the wavelengths of the electromagnetic radiation in the additional electrically insulating layer and the additional layer of polycrystalline semiconductor material, respectively.

Of course the invention is not limited to the embodiment described herein, but various modifications are possible for those skilled in the art without departing from the scope of the invention. For example, in the above embodiment, instead of a $CO_2$ laser, a CO laser or a neodymium-doped YAG laser may also be used. Furthermore, other semiconductor materials, such as, for example, a III-V material, such as GaAs, may be chosen for opto-electronic applications, or II-VI materials or a combination of GaAs and silicon may be chosen in one semiconductor device. If required, a different laser may be chosen having a wavelength at which the GaAs is practically completely transparent, such as a neodymium-doped YAG laser. Instead of silicon dioxide, silicon monoxide may also be used both in the intermediate layers and in the coating layer. Besides, amorphous silicon may be chosen for the layer 4.

## Claims

1. A method of converting polycrystalline or amorphous semiconductor material into practically monocrystalline semiconductor material, in which on a substrate a layer structure comprising a layer of polycrystalline or amorphous semiconductor material between a first electrically insulating layer and a coating layer is irradiated by a radiation source supplying practically monochromatic electromagnetic radiation, to which the polycrystalline or amorphous semiconductor material is practically completely transparent at least at room temperature, the energy being sufficient to heat the layer structure in such a manner that the polycrystalline or amorphous semiconductor material is converted at least locally into monocrystalline semiconductor material, characterized in that in the layer structure the coating layer has a thickness of practically $m/4.\lambda^I$ and the layer of polycrystalline or amorphous semiconductor material and the electrically insulating layer have thicknesses of practically $n/4.\lambda^{II}$ and $n'/4.\lambda^{III}$, where $\underline{m}$ is even and $\underline{n}$ and $\underline{n}'$ are odd, while $\lambda^I$, $\lambda^{II}$ and $\lambda^{III}$ are the wavelengths of the electromagnetic radiation in the coating layer, the layer of polycrystalline or amorphous semiconductor material and the first electrically insulating layer, respectively.

2. A method as claimed in Claim 1, characterized in that in the layer structure between the first electrically insulating layer and the substrate has at least a double layer comprising an additional electrically insulating layer and an additional layer of polycrystalline semiconductor material present thereon, the additional insulating layer and the additional layer of polycrystalline semiconductor material having thicknesses of practically $n''/4.\lambda^{IV}$ and $n'''/4.\lambda^V$, where n" and n''' are odd and $\lambda^{IV}$ and $\lambda^V$ are the wavelengths of the electromagnetic radiation in the additional insulating layer and the additional layer of polycrystalline semiconductor material, respectively.

3. A method as claimed in any one of the preceding Claims, characterized in that the substrate comprises a semiconductor body, in which circuit elements are formed.

4. A method as claimed in any one of the preceding Claims, characterized in that to obtain a better mutual adaptation, the layer structure is provided with at least one intermediate layer between a polycrystalline semiconductor layer and one or more of the other layers.

## Patentansprüche

1. Verfahren zum Umwandeln polykristallinen oder amorphen Halbleitermaterials zu insbesondere monokristallinem Halbleitermaterial, wobei auf einem Träger eine Schichtstruktur mit einer Schicht aus polykristallinem oder amorphem Halbleitermaterial zwischen einer ersten elektrisch isolierenden Schicht und einer Deckschicht, sowie einer Deckschicht durch eine nahezu monochromatische elektromagnetische Strahlung liefernde Strahlungsquelle bestrahlt wird, für welche Strahlung das polykristalline oder amorphe Halbleitermaterial wenigstens bei Raumtemperatur nahezu völlig durchlässig ist, wobei die Energie dazu ausreicht, die Schichtstruktur derart zu erwärmen, daß das polykristalline oder amorphe Halbleitermaterial wenigstens örtlich zu monokristallinem Halbleitermaterial umgewandelt wird, dadurch gekennzeichnet, daß in der Schichtstruktur die Deckschicht eine Dicke hat von praktisch $m/4.\lambda^I$ und die Schicht aus polykristallinem oder amorphem Halbleitermaterial und die elektrisch isolierende Schicht eine Dicke haben von praktisch $n/4.\lambda^{II}$ bzw. $n'/4.\lambda^{III}$, wobei m geradzahlig und n sowie n' ungeradzahlig sind, während $\lambda^I$, $\lambda^{II}$ und $\lambda^{III}$ die Wellenlängen der elektromagnetischen Strahlung in der Deckschicht, der Schicht aus polykristallinem oder amorphem Halbleitermaterial bzw. der ersten elektrisch isolierenden Schicht sind.

2. Verfahren nach Anspruch 1, dadurch gekennzeichnet, daß die Schichtstruktur zwischen der ersten elektrisch isolierenden Schicht und dem Träger wenigstens eine Doppelschicht aufweist mit einer zusätzlichen elektrisch isolierenden Schicht und einer darauf liegenden zusätzlichen Schicht aus polykristallinem Halbleitermaterial, wobei die zusätzliche Isolierschicht und die zusätzliche Schicht aus polykristallinem Halbleitermaterial eine Dicke hat von praktisch $n''/4.\lambda^{IV}$ bzw. $n'''/4.\lambda^V$, wobei n" und n''' ungeradzahlig sind und $\lambda^{IV}$ und $\lambda^V$ die Wellenlängen der elektromagnetischen Strahlung in der zusätzlichen Isolierschicht bzw. in der zusätzlichen Schicht aus polykristallinem Halbleitermaterial sind.

3. Verfahren nach einem der vorstehenden Ansprüche, dadurch gekennzeichnet, daß der Träger einen Halbleiterkörper aufweist, in dem Schaltungselemente gebildet sind.

4. Verfahren nach einem der vorstehenden Ansprüche, dadurch gekennzeichnet, daß zum Erzielen einer besseren gegenseitigen Anpassung die Schichtstruktur mit wenigstens einer Zwischenschicht zwischen einer polykristallinen Halbleiterschicht und einer oder mehreren anderen Schichten versehen ist.

**Revendications**

1. Procédé pour convertir un matériau semi-conducteur polycristallin ou amorphe en un matériau semi-conducteur pratiquement monocristallin, dans lequel, sur un substrat, une structure en couches comprenant une couche de matériau semi-conducteur polycristallin ou amorphe entre une première couche électriquement isolante et une couche de revêtement est irradiée à l'aide d'une source de rayonnement qui émet un rayonnement électromagnétique pratiquement monochromatique pour lequel le matériau semi-conducteur polycristallin ou amorphe est pratiquement tout à fait transparent au moins à la température ambiante, l'énergie étant suffisante pour chauffer la structure en couches d'une manière telle que le matériau semi-conducteur polycristallin ou amorphe soit converti au moins localement en matériau semi-conducteur monocristallin, caractérisé en ce que la couche de revêtement dans la structure en couches a une épaisseur de pratiquement $m/4.\lambda^I$ et la couche de matériau semi-conducteur polycristallin ou amorphe et la couche électriquement isolante ont des épaisseurs de pratiquement $n/4.\lambda^{II}$ et $n'/4.\lambda^{III}$, respectivement, où $m$ est pair et $n$ et $n'$ sont impairs et $\lambda^I$, $\lambda^{II}$ et $\lambda^{III}$ sont les longueurs d'onde du rayonnement électromagnétique dans la couche de revêtement, la couche de matériau semi-conducteur polycristallin ou amorphe et la première couche électriquement isolante, respectivement.

2. Procédé suivant la revendication 1, caractérisé en ce que la structure en couches entre la première couche électriquement isolante et le substrat a au moins une double couche comprenant une couche électriquement isolante supplémentaire et une couche supplémentaire de matériau semi-conducteur polycristallin, la couche isolante supplémentaire et la couche supplémentaire de matériau semi-conducteur polycristallin ayant des épaisseurs de pratiquement $n''/4.\lambda^{IV}$ et $n'''/4.\lambda^V$, où $n''$ et $n'''$ sont impairs et $\lambda^{IV}$ et $\lambda^V$ sont les longueurs d'onde du rayonnement électromagnétique dans la couche isolante supplémentaire et la couche supplémentaire de matériau semi-conducteur polycristallin, respectivement.

3. Procédé suivant l'une quelconque des revendications précédentes, caractérisé en ce que le substrat comprend un corps semi-conducteur dans lequel des éléments de circuit sont formés.

4. Procédé suivant l'une quelconque des revendications précédentes, caractérisé en ce que pour obtenir une meilleure adaptation mutuelle, la structure en couches est munie d'au moins une couche intermédiaire entre une couche de semi-conducteur polycristallin et une ou plusieurs des autres couches.

FIG.1

FIG.2

FIG.3